(19) **Europäisches Patentamt European Patent Office Office européen des brevets**

(11) **EP 2 047 489 B1**

(12) **FASCICULE DE BREVET EUROPEEN**

(45) Date de publication et mention de la délivrance du brevet:
**28.08.2019 Bulletin 2019/35**

(51) Int Cl.:
**H01F 10/32** (2006.01)

(21) Numéro de dépôt: **07823580.1**

(22) Date de dépôt: **13.07.2007**

(86) Numéro de dépôt international:
**PCT/FR2007/051659**

(87) Numéro de publication internationale:
**WO 2008/015354 (07.02.2008 Gazette 2008/06)**

(54) **DISPOSITIF MAGNÉTIQUE EN COUCHES MINCES À FORTE POLARISATION EN SPIN PERPENDICULAIRE AU PLAN DES COUCHES, JONCTION TUNNEL MAGNÉTIQUE ET VANNE DE SPIN METTANT EN OEUVRE UN TEL DISPOSITIF**

MAGNETISCHE VORRICHTUNG AUS DÜNNEN SCHICHTEN MIT EINER STARKEN POLARISATION SENKRECHT ZUR SCHICHTOBERFLÄCHE, MAGNETISCHER TUNNELKONTAKT UND SPINVENTIL BEI DENEN DIESE VORRICHTUNG EINGESETZT WIRD

THIN-LAYERED MAGNETIC DEVICE WITH HIGH SPIN POLARIZATION PERPENDICULAR TO THE PLANE OF THE LAYERS, AND MAGNETIC TUNNEL JUNCTION AND SPIN VALVE USING SUCH A DEVICE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **03.08.2006 FR 0653266**
**04.12.2006 US 868429 P**

(43) Date de publication de la demande:
**15.04.2009 Bulletin 2009/16**

(73) Titulaires:
• **Commissariat à l'Énergie Atomique et aux Énergies Alternatives 75015 Paris (FR)**
• **Centre National de la Recherche Scientifique 75794 Paris Cedex 16 (FR)**

(72) Inventeurs:
• **RODMACQ, Bernard F-38113 Veurey Voroize (FR)**
• **DIENY, Bernard F-38250 Lans En Vercors (FR)**

(74) Mandataire: **Cabinet Laurent & Charras Le Contemporain 50 Chemin de la Bruyère 69574 Dardilly Cedex (FR)**

(56) Documents cités:

**US-A1- 2002 101 692**

• **D. RAVELOSONA ET AL.: "Nanometer scale observation of high efficiency thermally assisted current-driven domain wall depinning" PHYSICAL REVIEW LETTERS, vol. 95, 8 septembre 2005 (2005-09-08), pages 117203-1-117203-4, XP002425519 cité dans la demande**
• **DATABASE INSPEC [Online] THE INSTITUTION OF ELECTRICAL ENGINEERS, STEVENAGE, GB; 2002, SVALOV A V ET AL: "Spin-valve structures with Co/Tb-based multilayers" XP002466975 Database accession no. 7479729 & INTERMAG EUROPE 2002 DIGEST OF TECHNICAL PAPERS. 2002 IEEE INTERNATIONAL MAGNETICS CONFERENCE 28 APRIL-2 MAY 2002 AMSTERDAM, NETHERLANDS, 2002, page ES7, Intermag Europe 2002 Digest of Technical Papers. 2002 IEEE International Magnetics Conference (Cat.No.02CH37323) IEEE Piscataway, NJ, USA ISBN: 0-7803-7365-0**
• **NISHIMURA N ET AL: "MAGNETIC TUNNEL JUNCTION DEVICE WITH PERPENDICULAR MAGNETIZATION FILMS FOR HIGH-DENSITY MAGNETIC RANDOM ACCESS MEMORY" JOURNAL OF APPLIED PHYSICS, AMERICAN INSTITUTE OF PHYSICS. NEW YORK, US, vol. 91, no. 8, 15 avril 2002 (2002-04-15), pages 5246-5249, XP001123816 ISSN: 0021-8979**

**Description**

**DOMAINE TECHNIQUE DE L'INVENTION**

La présente invention se rattache au domaine des matériaux 'magnétiques, plus particulièrement destinés à être mis en oeuvre d'une part au sein des mémoires magnétiques à accès aléatoire non volatiles, permettant le stockage et la lecture de données dans des systèmes électroniques, et d'autre part dans le domaine des oscillateurs radiofréquence mettant en oeuvre la technologie des systèmes magnétiques en couches minces.

**ETAT ANTERIEUR DE LA TECHNIQUE**

Dans le domaine des mémoires magnétiques, les mémoires magnétiques dites M-RAM (pour *Magnetic Random Access Memories)* constituées d'une jonction tunnel magnétique ont fait l'objet d'un très grand intérêt depuis la mise au point de telles jonctions tunnel présentant une forte magnétorésistance à température ambiante. Ces mémoires magnétiques à accès aléatoire présentent de nombreux atouts :

- rapidité (quelques nanosecondes de temps d'écriture et de lecture) ;
- non volatilité ;
- absence de fatigue à la lecture et à l'écriture ;
- insensibilité aux radiations ionisantes.

Ce faisant, elles sont appelées à remplacer les mémoires de technologie plus traditionnelle, basées sur l'état de charge d'une capacité (D-RAM, S-RAM, Flash).

Dans ces mémoires magnétiques, le codage de l'information (« 0 » ou « 1 ») dépend de l'orientation relative (parallèle ou antiparallèle) de l'aimantation de deux couches magnétiques de coercivités différentes, une des couches étant dite « libre », c'est-à-dire dont la direction de l'aimantation peut être modifiée par application d'un champ magnétique extérieur de faible intensité, l'autre couche étant dite « piégée », c'est-à-dire dont la direction de l'aimantation est insensible à ce même champ magnétique extérieur.

Ce changement d'orientation relative des aimantations modifie la résistance électrique de l'empilement des deux couches ainsi constituées, et la lecture de l'état magnétique se fait par une mesure de tension électrique suite à l'injection d'un courant électrique dans une direction perpendiculaire au plan des couches.

L'écriture de l'information se fait généralement par l'envoi de deux impulsions électriques dans des conducteurs se croisant à angle droit à proximité du point où est située la cellule mémoire considérée. L'addition des deux champs magnétiques créés par ces impulsions électriques au niveau de la cellule et le sens des courants électriques injectés permet de changer la direction de l'aimantation de la couche « libre » et donc l'inscription de l'information en question.

Cependant, l'existence d'une distribution relativement large des champs de retournement de l'ensemble des points mémoire, due au mode de fabrication, nécessite, pour assurer le changement d'orientation de l'aimantation, la mise en oeuvre d'un champ magnétique extérieur supérieur au champ de retournement le plus élevé de ladite distribution. Ce faisant, on risque de renverser accidentellement certains points mémoire situés sur la ligne et/ou sur la colonne correspondante, dont le champ de retournement, éventuellement situé dans la partie basse de la distribution, est plus faible que le champ magnétique généré par la ligne ou la colonne seule.

Si l'on souhaite s'assurer qu'aucun point mémoire ne soit écrit par une ligne ou une colonne seule, il faut dans ce cas limiter le courant d'écriture de façon à ne jamais dépasser pour ces points mémoire le champ magnétique correspondant à la partie basse de la distribution, au risque de ne pas écrire le point mémoire sélectionné à l'intersection desdites ligne et colonne si le champ de retournement de ce point mémoire est dans la partie haute de la distribution. En d'autres termes, cette architecture à sélection par champs magnétiques à l'aide de lignes et de colonnes de conducteur peut facilement conduire à des erreurs d'adressage à l'écriture.

En outre, il est généralement observé que la valeur moyenne du champ de retournement augmente lorsque la taille des points mémoire diminue. Ce faisant, un courant électrique d'autant plus important est nécessaire pour assurer le retournement effectif de l'aimantation du point mémoire induisant corollairement l'augmentation de la puissance électrique requise.

De fait, il a été proposé une autre technique d'écriture dénommée « retournement d'aimantation par courant polarisé en spin ». Cette technologie consiste à réaliser l'écriture des points mémoire non plus par un champ magnétique extérieur mais par un courant électrique polarisé en spin. En effet, il a été démontré qu'un courant polarisé en spin était capable de provoquer une précession, voire un renversement de l'aimantation par transfert du moment angulaire de spin entre les porteurs polarisés et le moment magnétique de la couche considérée (voir par exemple US A 5 695 864).

L'un des avantages de cette technique réside dans le fait que c'est la même ligne de courant qui est utilisée à la fois pour la lecture et l'écriture de l'information magnétique, ceci simplifiant grandement l'architecture du dispositif.

Ainsi, au passage à travers les différentes couches de l'empilement magnétique considéré, le courant électrique se polarise, le spin de l'électron tendant à s'aligner sur la direction locale de l'aimantation. Si aucune dépolarisation ne se produit dans les couches traversées, cette polarisation se conserve dans la deuxième couche magnétique et induit en retour une précession de l'aimantation de la couche magnétique « libre » autour de la direction de polarisation.

Lorsque la densité de courant électrique augmente, l'angle du cône de précession augmente jusqu'à éventuellement dépasser 90° pour un certain courant critique, provoquant ainsi le retournement de l'aimantation de la couche « libre » vers une direction opposée à sa direction initiale.

Cependant, cette technologie particulière se heurte à une sérieuse limitation. En effet, dans cette configuration, afin d'aboutir au renversement de l'aimantation, il est nécessaire de vaincre le champ démagnétisant de ladite couche « libre ». Ce champ démagnétisant tend à maintenir, pour des couches magnétiques minces, l'aimantation dans le plan de ladite couche. Or, ce champ démagnétisant étant proportionnel à l'aimantation du matériau, il apparaît que le renversement de l'aimantation nécessite l'injection de courant de forte intensité susceptible de détériorer le dispositif, notamment par claquage électrique de la barrière isolante séparant les deux couches magnétiques dans le cas d'une jonction tunnel magnétique.

Les systèmes magnétiques en couches minces sont également mis en oeuvre dans le domaine des oscillateurs radiofréquence. Ceux-ci connaissent d'importants développements directement corrélés au développement correspondant de la téléphonie mobile. En effet, celle-ci a induit la mise en oeuvre d'oscillateurs à très large gamme de bandes de fréquences, et particulièrement performants en bruit de phase, et donc à fort facteur de qualité.

Une solution technique pour satisfaire cette demande consiste à mettre en oeuvre des oscillateurs radiofréquence à électronique de spin. De tels oscillateurs permettent de disposer d'une large bande de fréquences avec un facteur de qualité Q élevé, outre une accordabilité en fréquence aisée, et au surplus, permettant une architecture relativement simple.

La polarisation en spin d'un courant électrique, à l'origine des phénomènes magnétorésistifs dans les multicouches magnétiques telle que la magnétorésistance géante ou la magnétorésistance tunnel, est connue. De plus, un tel courant polarisé en spin traversant une couche mince magnétique peut agir sur l'aimantation d'une nanostructure magnétique en induisant un renversement de son aimantation en l'absence de tout champ magnétique externe, ou également en générant des excitations magnétiques entretenues aussi dénommées oscillations. La fréquence de ces excitations dépend notamment de la densité de courant traversant la nanostructure.

L'utilisation de l'effet de genèse d'excitations magnétiques entretenues dans un dispositif magnétorésistif permet de convertir cet effet en une modulation de résistance électrique directement utilisable dans les circuits électroniques, avec corollairement la possibilité d'agir au niveau de la fréquence.

Cependant, l'un des problèmes rencontrés avec ces oscillateurs radiofréquence réside dans la densité du courant polarisé en spin à injecter dans le système magnétique en question, susceptible de conduire à une détérioration du dispositif par suite de phénomènes de claquage électrique ou d'électro-migration.

Quelle que soit l'application envisagée, on cherche à obtenir, afin de réduire les densités de courant nécessaires à l'écriture de l'information, soit un matériau magnétique en couche mince, dont l'aimantation, spontanément parallèle au plan de cette couche, peut facilement être orientée dans une direction perpendiculaire sous l'action d'un champ magnétique (ou d'un courant polarisé) de faible amplitude, soit un matériau magnétique en couche mince dont l'aimantation est spontanément (sans champ magnétique extérieur ni courant polarisé) perpendiculaire au plan de cette couche.

A cette fin, il va être rappelé quelques principes physiques à l'origine de ces phénomènes. Pour une couche magnétique unique, c'est-à-dire par exemple une couche mince d'un matériau magnétique déposée sur un substrat n'entraînant aucune interaction particulière avec ladite couche, l'effet de forme (le fait que les dimensions latérales de cette couche soient beaucoup plus grandes que son épaisseur) tend à maintenir la direction de son aimantation dans son plan (aimantation dite "planaire").

Si l'on applique un champ magnétique d'amplitude croissante dans une direction perpendiculaire au plan de cette couche, la direction de son aimantation va progressivement sortir du plan pour s'orienter parallèlement à ce champ appliqué. Elle sera donc perpendiculaire au plan quand le champ magnétique appliqué atteindra une valeur de champ de saturation perpendiculaire $H_{sp}$ égale à un champ dit "champ démagnétisant" $H_{dm}$ proportionnel à l'aimantation par unité de volume $M_s$ de ce matériau magnétique, selon la relation:

$$H_{sp} = H_{dm} = 4\pi M_s$$

Pour fixer les idées, ce champ $H_{sp}$ est de l'ordre de $18*1000/4\pi$ kA/m (18 kOe) pour un matériau comme le cobalt et de $6*1000/4\pi$ kA/m (6 kOe) pour du nickel. Une première façon de réduire ce champ $H_{sp}$ est donc d'utiliser un matériau magnétique de faible aimantation. Cependant, ceci peut se révéler désavantageux pour certaines applications dans lesquelles le signal utile dépend de cette même aimantation.

Une deuxième façon de réduire $H_{sp}$ est d'introduire un terme supplémentaire de signe opposé à $H_{dm}$. Ce terme dit "d'anisotropie perpendiculaire" $H_{ap}$ peut avoir pour origine, comme indiqué par la suite dans l'exposé de l'art antérieur, soit une anisotropie volumique d'origine magnétocristalline ou induite par des contraintes élastiques de croissance, soit une anisotropie d'interface due à des interactions électroniques interfaciales. Un cas typique est par exemple l'influence d'une couche de platine au contact d'une couche magnétique de cobalt, de nickel ou de fer.

En présence de ce terme supplémentaire, le champ de saturation perpendiculaire peut s'écrire de la façon suivante:

$$H_{sp} = H_{dm} - H_{ap}$$

D'une manière qualitative, le champ de saturation perpendiculaire $H_{sp}$ va donc diminuer de façon régulière lorsque $H_{ap}$ va augmenter, l'aimantation de la couche magnétique étant toujours parallèle au plan, jusqu'à tendre vers zéro, limite en deçà de laquelle, lorsque $H_{ap}$ sera supérieur à $H_{dm}$, l'aimantation de la couche magnétique sera spontanément (c'est à dire sans champ magnétique appliqué) perpendiculaire au plan de la couche.

Il faut également rajouter que, dans le cas d'une anisotropie perpendiculaire d'origine interfaciale, $H_{ap}$ sera en première approximation inversement proportionnel à l'épaisseur e de la couche magnétique, selon:

$$H_{ap} = C + K_{ap}/e$$

où C est une constante dépendant des propriétés volumiques de la couche magnétique et où $K_{ap}$, constante d'anisotropie perpendiculaire, dépend de la structure intime du matériau en contact avec la couche magnétique et de la qualité structurale de l'interface.

Cette dépendance du champ d'anisotropie perpendiculaire en fonction de l'épaisseur de la couche magnétique signifie donc qu'il ne sera possible de stabiliser l'aimantation dans une direction perpendiculaire au plan que pour de faibles épaisseurs de couche magnétique, mais que par contre l'épaisseur critique de transition perpendiculaire/planaire augmentera avec l'amplitude de $K_{ap}$.

Un premier but de l'invention visant des applications de type oscillateurs RF ou mémoires MRAM est de proposer un moyen de réalisation d'une couche magnétique à aimantation perpendiculaire au plan de cette couche pouvant être intégrée dans des structures de type vannes de spin ou jonctions tunnel, dont les aimantations des couches libre et piégée sont, elles, planaires. Cette couche magnétique supplémentaire à aimantation perpendiculaire est destinée à servir de « polariseur » (voir document US 6 532 164).

Dans un tel « polariseur », le spin des électrons du courant injecté dans le système magnétique est couplé à l'aimantation selon une direction perpendiculaire au plan des couches, et l'axe du cône de précession de l'aimantation est donc lui aussi perpendiculaire à ce plan. La rotation de l'aimantation de la couche magnétique « libre » s'effectue donc, pour des courants faibles, dans un plan pratiquement confondu avec le plan des couches.

L'utilisation d'impulsions de courant synchronisées ainsi que l'existence d'une anisotropie magnétique planaire uniaxiale de la couche « libre » permettent de renverser facilement la direction de l'aimantation en lui faisant effectuer une demi-précession dans le plan de la couche.

La mise en oeuvre d'un tel polariseur dans la réalisation d'oscillateurs radiofréquence s'avère également particulièrement recherchée. Dans une telle configuration, le courant polarisé en spin est injecté de façon continue à travers l'empilement et non plus par impulsions. Ce faisant, le mouvement de précession de l'aimantation est entretenu au lieu de ne conduire qu'à une demi-précession pour l'écriture dans le cas de la mémoire magnétique.

Si l'aimantation qui précesse est celle de la couche douce (« libre ») d'une jonction tunnel déposée au dessus de la couche polarisante, il résulte de ce mouvement de précession une variation oscillante de la résistance de l'empilement, liée à l'effet de magnétorésistance tunnel de la jonction. Ceci conduit à l'apparition d'une tension oscillante entre les deux surfaces opposées de l'empilement, laquelle peut être utilisée pour la réalisation d'un oscillateur radiofréquence accordable, la fréquence étant directement liée à l'intensité du courant injecté.

Il est important de noter que, pour être opérationnelles, ces couches magnétiques à aimantation perpendiculaire ne doivent pas contenir de matériaux fortement dépolarisant pour les électrons au voisinage de la zone active de la structure.

A titre d'exemple, dans le cas du polariseur perpendiculaire mentionné précédemment, l'insertion d'une couche mince de platine entre ce polariseur et les deux couches magnétiques de la structure de type vanne de spin ou jonction tunnel magnétique détruirait complètement la polarisation des électrons induite par ce polariseur. Par la suite, on désignera par épaisseur magnétique "utile" l'épaisseur de la couche magnétique à aimantation perpendiculaire comptée, par rapport au sens de déplacement des électrons, au-delà de l'éventuelle dernière couche de matériau fortement dépolarisant tel le platine, le palladium ou l'or.

Un autre objet de la présente invention visant les applications de type MRAM est de proposer un moyen de réalisation de couches minces magnétiques susceptibles de s'intégrer dans des structures de type vannes de spin ou jonctions tunnel magnétiques à aimantation perpendiculaire, dont les aimantations des deux couches magnétiques actives (couche « piégée » et couche « libre ») seraient perpendiculaires au plan.

Un troisième but de l'invention est de proposer un moyen de réalisation d'une couche magnétique à aimantation planaire, c'est-à-dire, située dans le plan des couches qui la constituent, pour laquelle son champ démagnétisant est partiellement compensé par un terme d'anisotropie perpendiculaire, permettant ainsi de réduire la densité de courant nécessaire au retournement de l'aimantation de cette couche. Cette couche magnétique pourra par exemple être utilisée comme « couche libre » dans des structures de type vannes de spin ou jonctions tunnel à aimantation planaire.

Différentes méthodes ont été proposées afin de réaliser des couches minces magnétiques à aimantation perpendiculaire à leur plan, et susceptibles d'être utilisées dans certains des types d'applications cités ci-dessus.

Il a été proposé (Daalderop, Kelly et den Broeder, Physical Review Letters 68, 682, 1992) la réalisation de multicouches cobalt/nickel par évaporation sous vide sur une couche tampon d'or recouvrant le substrat. La fenêtre de fonctionnement est relativement étroite (par exemple, pour une épaisseur de cobalt de 0,4 nm, l'épaisseur des couches de nickel doit être comprise entre 0,6 et 0,8 nm). De plus, le résultat obtenu dépend selon les auteurs de façon critique des conditions de préparation.

Dans le même ordre d'idée, Ravelosona et al (Physical Review Letters 95, 117203, 2005) ont proposé une combinaison de multicouches (cobalt/platine)/(cobalt/nickel), également préparées par évaporation sous vide. Dans ce cas, l'épaisseur magnétique utile (c'est-à-dire au-dessus de la dernière couche de platine) est très faible, équivalente à environ 1,0 nm de cobalt.

Dans ces deux cas, il apparaît nécessaire que la croissance des couches magnétiques soit réalisée par évaporation, technique peu compatible avec une production industrielle. La raison en est que cette propriété d'anisotropie magnétique perpendiculaire est due à des effets de contraintes élastiques entre les couches de nickel et de cobalt, de paramètres cristallins légèrement différents. Ceci explique à la fois la nécessité de l'utilisation d'une telle technique de préparation, ainsi que la difficulté de réalisation de telles structures. En tout état de cause, la production à l'échelle industrielle est exclue avec cette technologie, tout du moins à des coûts acceptables. De plus, ces effets de contraintes élastiques n'apparaissent que pour certains matériaux magnétiques cristallins. Il est donc exclu par exemple d'utiliser, soit d'autres matériaux magnétiques, soit des alliages magnétiques amorphes.

Il a été proposé dans le document US 6 835 646 concernant des structures du type substrat/couche tampon/Ni/FeMn/Cu, un procédé dans lequel la croissance du nickel doit être « épitaxiale ». Cela signifie que les couches déposées successivement doivent adopter la symétrie et la distance inter-atomique des couches sous-jacentes. De plus, la couche tampon doit être soit du cuivre monocristallin, d'orientation cristallographique (002), soit du diamant, d'orientation cristallographique (001). Ceci ne peut être obtenu que par une croissance sur un substrat de silicium monocristallin d'orientation cristallographique (001), et de plus décapé chimiquement afin d'obtenir la bonne orientation de la couche tampon de cuivre ou de diamant.

Ce mode de réalisation s'avère ainsi particulièrement lourd à mettre en oeuvre en raison de la croissance par épitaxie et de la nature monocristalline des substrats. De plus, aucun autre matériau magnétique que le nickel ne donnerait le résultat escompté.

Un autre mode de réalisation a été proposé par Nishimura et al (Journal of Applied Physics 91, 5246, 2002, US 6 844 605), en utilisant des structures à base de métaux de terres rares du type $GdFeCo/CoFe/Al_2O_3/CoFe/TbFeCo$, avec des épaisseurs « utiles » de métal magnétique (alliage cobalt-fer) de l'ordre de 1 nm.

Ce mode de réalisation nécessite l'utilisation d'alliages à base de métaux de la famille des Terres Rares (gadolinium, terbium), réputés très polluants et proscrits dans l'industrie

De même US 2002/101692 A1 propose une multicouche magnétique à aimantation perpendiculaire au plan des couches.

Il ressort des considérations précédentes qu'aucune des solutions proposées ne permet la réalisation, pour des matériaux magnétiques usuels et par une méthode de préparation simple, de couches minces à aimantation perpendiculaire à leur plan et possédant une épaisseur magnétique « utile » suffisante pour les applications visées. En effet, soit les épaisseurs magnétiques auxquelles on aboutit s'avèrent trop réduites pour disposer d'une polarisation exploitable du courant électrique traversant perpendiculairement le plan des couches, soit il est nécessaire d'employer un matériau magnétique spécifique déposé par une méthode bien particulière afin d'atteindre des épaisseurs magnétiques plus importantes.

## EXPOSE DE L'INVENTION

L'invention concerne en premier lieu un dispositif magnétique en couches minces selon la revendication 1.

Ainsi, les deux couches magnétiques précitées étant fortement couplées entre elles, elles se comportent comme une couche unique, alliant les propriétés recherchées, à savoir anisotropie perpendiculaire apportée par la première couche, et polarisation en spin apportée par la seconde.

La couche non magnétique ne sépare jamais ces deux couches, et a principalement pour finalité de minimiser d'éventuelles interactions avec d'autres couches magnétiques d'une structure au sein de laquelle l'ensemble composite précité est susceptible d'être intégré.

Ainsi, ce dispositif peut-il constituer un « demi » motif, qui peut être ajouté à une structure complète de type vanne de spin ou jonction tunnel, ou être « doublé » pour ainsi constituer en tant que tel ce type de structure.

Selon l'invention, la couche magnétique réalisée en un matériau magnétique présentant une forte anisotropie magnétique perpendiculaire peut être constituée d'un alliage ou d'une multicouche constitués de matériaux choisis dans le groupe comprenant le cobalt, le platine, le fer, le nickel, le palladium, l'or et le cuivre.

La nature, le nombre et l'épaisseur des différentes couches élémentaires constitutives de cette couche sont choisis afin de maximiser l'énergie d'anisotropie magnétique perpendiculaire de l'ensemble constitué desdites deux couches magnétiques, ceci dans le but d'obtenir les caractéristiques souhaitées pour une épaisseur de la couche réalisée en matériau ferromagnétique la plus grande possible, permettant ainsi une polarisation optimale des électrons du courant électrique traversant cette structure.

Selon l'invention, la couche réalisée en matériau ferromagnétique est constituée d'un matériau magnétique choisi dans le groupe comprenant le cobalt, le fer, le nickel, ou leurs alliages binaires tel que par exemple le Permalloy $Ni_{80}Fe_{20}$, ou ternaires, ainsi que les alliages magnétiques, cristallisés ou amorphes, contenant en plus d'un ou des éléments magnétiques ainsi cités, des ajouts de matériaux non magnétiques tels que par exemple le bore, le silicium, le phosphore, le carbone, le zirconium, l'hafnium ou leurs alliages.

Cependant, cette couche peut également être constituée d'une multicouche de type métal magnétique/métal magnétique (de type Co/NiFe par exemple), ou métal magnétique/métal non magnétique (de type Co/Cu par exemple).

Corollairement, l'épaisseur de cette couche permet d'optimiser la polarisation en spin d'un courant électrique la traversant.

En régime diffusif, la longueur pertinente pour construire une polarisation en spin est la longueur de diffusion de spin $1_{SF}$. Ainsi la polarisation en spin croit comme une fonction $(1-\exp(-e/1_{SF}))$ en fonction de l'épaisseur e de ladite couche réalisée en matériau ferromagnétique. Cette longueur de diffusion de spin est typiquement de 4.5 nm à 300K dans le Permalloy $Ni_{80}Fe_{20}$, et de 20 nm dans le cobalt. Le régime diffusif est le régime rencontré par exemple si le polariseur ainsi réalisé est séparé de la couche magnétique douce d'une jonction tunnel par un espaceur métallique non magnétique en vue de la réalisation d'une cellule MRAM ou d'un oscillateur radiofréquence.

En régime tunnel, la polarisation des électrons tunnel est déterminée par les densités d'états électroniques au voisinage de la barrière tunnel. L'épaisseur optimale pour obtenir une forte polarisation en spin est alors déterminée par l'épaisseur de la couche magnétique en contact avec la barrière qui permet d'établir un fort contraste de densités d'états entre les électrons de spin up et down près de l'énergie de Fermi au voisinage de l'interface avec la barrière tunnel. Cette épaisseur est typiquement de quelques plans atomiques et dépend de la rugosité des interfaces et des matériaux en jeu. Un autre point à prendre en compte dans la détermination de l'épaisseur de cette couche réalisée en matériau ferromagnétique est la stabilité thermique de son aimantation. Une couche excessivement fine (inférieure en épaisseur à typiquement 1 nm) pourrait être le siège de fluctuations magnétiques activées thermiquement, voire de phénomènes de superparamagnétisme bien connus de l'homme du métier.

D'une façon générale, plus la polarisation en spin sera importante et plus la densité de courant nécessaire pour écrire un point mémoire mettant en oeuvre un tel dispositif magnétique, ou pour disposer d'un oscillateur radiofréquence à large bande de fréquence, pourra être abaissée.

Selon une caractéristique avantageuse, est interposée entre le dispositif magnétique ainsi défini et le substrat, une couche, dite « couche tampon », réalisée en un ou plusieurs matériaux choisis dans le groupe comprenant le tantale, le chrome, le titane, le nitrure de titane, le cuivre, l'or, le palladium, l'argent et/ou leurs alliages. Cette couche tampon est plus particulièrement destinée à optimiser la croissance des couches magnétiques mentionnées précédemment, outre à favoriser leur adhérence entre elles et le substrat. Elle permet également de promouvoir la planéité desdites couches en raison de l'adaptation des paramètres de maille qu'elle induit. Elle peut également servir d'amenée de courant inférieure du dispositif.

Selon l'invention, le dispositif magnétique est surmonté d'une troisième couche non magnétique réalisée soit en métal (par exemple du cuivre) soit en isolant (par exemple en oxyde de silicium, de magnésium ou d'aluminium). Cette troisième couche a pour fonction de protéger la couche magnétique immédiatement inférieure du dispositif magnétique contre la corrosion et peut également servir d'amenée de courant supérieure du dispositif. Elle a également pour finalité de découpler magnétiquement la couche magnétique réalisée en matériau ferromagnétique par rapport à une autre couche magnétique, susceptible d'être déposée au dessus de ladite troisième couche, par exemple dans le cadre de la réalisation d'une jonction tunnel magnétique ou d'un oscillateur radiofréquence.

En revanche, cette troisième couche est choisie afin de n'induire aucun effet particulier, ni en ce qui concerne les propriétés d'anisotropie magnétique perpendiculaire, ni en ce qui concerne une quelconque dépolarisation des électrons traversant la structure.

Selon l'invention, la réalisation de ce dispositif magnétique est obtenue par dépôt des différentes couches par pulvérisation cathodique.

Ce dispositif magnétique peut avantageusement être mis en oeuvre, selon les revendications 11 à 16:

- comme couche polarisante perpendiculaire au sein de vannes de spin ou de jonctions tunnel magnétiques à aimantation planaire,
  - comme couches actives, c'est à dire à la fois couche libre et couche piégée, dans des structures à aimantation perpendiculaire,
  - comme couche active, c'est à dire comme couche « libre » à faible champ démagnétisant, dans des structures à aimantation planaire.

## BREVE DESCRIPTION DES DESSINS

La figure 1 est une représentation schématique d'une première forme de réalisation du dispositif magnétique conforme à l'invention.

La figure 2 est une représentation graphique illustrant la variation de l'aimantation rémanente mesurée en champ perpendiculaire, en fonction de l'épaisseur équivalente de cobalt pour des structures du type de la figure 1.

La figure 3 est une représentation schématique illustrant une seconde forme de réalisation de l'invention.

La figure 4 est une représentation graphique illustrant la variation de l'aimantation rémanente (mesurée en champ perpendiculaire) en fonction de l'épaisseur équivalente de cobalt pour les structures de la figure 3.

La figure 5 est une représentation schématique d'une troisième forme de réalisation de l'invention.

La figure 6 est une représentation schématique d'une quatrième forme de réalisation de l'invention.

La figure 7 est une représentation graphique illustrant la variation du champ de saturation (mesurée en champ perpendiculaire) en fonction de l'épaisseur équivalente de cobalt constituant la couche libre de la structure du type de la figure 6.

La figure 8 est une représentation schématique d'une cinquième forme de réalisation de l'invention.

## DESCRIPTION DES MODES PARTICULIERS DE REALISATION DE L'INVENTION

Au préalable, il va être rappelé le phénomène de polarisation de spin pour les électrons circulant dans des dispositifs, notamment à jonction tunnel ou à vanne de spin.

Un courant électrique circulant dans un conducteur est constitué d'électrons dont le spin n'a aucune raison *a priori* d'être orienté dans une direction particulière. Cependant, à la traversée d'une couche magnétique présentant une aimantation particulière, les spins desdits électrons se trouvent orientés par des phénomènes d'échange de moments magnétiques, de sorte que ces électrons sortant de cette couche présentent un spin polarisé.

Une telle couche ou un ensemble de telles couches constituent un polariseur. Ce phénomène peut jouer aussi bien en transmission (à travers une couche) qu'en réflexion (sur certaines couches) selon la direction de circulation du courant. Il peut également jouer en sens inverse, en ce sens qu'il laisse alors passer de préférence les électrons ayant un spin polarisé selon une certaine direction. La fonction de la couche est alors celle d'un analyseur.

Ainsi dans le cadre des mémoires magnétiques à écriture par retournement d'aimantation par courant polarisé en spin, lorsque le courant électrique traverse une première couche dite « piégée », il se polarise en ce sens que le spin de l'électron tend à s'aligner avec la direction locale de l'aimantation. Si aucune couche fortement dépolarisante ne sépare cette première couche magnétique d'une seconde magnétique dite « libre » en ce sens qu'elle n'a pas d'orientation d'aimantation particulière, cette polarisation du spin des électrons induit en retour une précession de l'aimantation de ladite seconde couche magnétique « libre » autour de la direction de polarisation.

Dans le cas de systèmes magnétiques à aimantation planaire, lorsque la densité du courant électrique traversant ces couches augmente, l'angle du cône de précession augmente jusqu'à éventuellement dépasser 90° pour un certain courant critique, provoquant ainsi le retournement de l'aimantation de la couche « libre ». Cependant, afin d'aboutir à un tel retournement, il est nécessaire de vaincre le champ démagnétisant de la couche libre, étant rappelé que ce champ démagnétisant tend à maintenir, pour des couches magnétiques minces, l'aimantation dans le plan.

Cette grandeur physique étant proportionnelle à l'aimantation du matériau, en conséquence, le renversement de l'aimantation nécessite l'injection de courant de forte densité pour les matériaux magnétiques usuels, insusceptible d'être supporté par les dispositifs magnétiques de type jonctions tunnel.

Un intérêt donc de la présente invention réside dans la mise en oeuvre de dispositifs magnétiques permettant, par réduction du champ démagnétisant, de limiter ces densités de courant pour, dans le cadre de la réalisation de mémoires magnétiques, optimiser leur fonctionnement.

Selon l'invention, le dispositif magnétique met en oeuvre un substrat courant et notamment non forcément monocristallin. Un tel substrat est par exemple constitué de silice ou de silicium oxydé. Cette oxydation peut résulter d'une oxydation de nature thermique, ou peut provenir de l'oxydation naturelle du silicium.

Ce substrat, quand il est amorphe, n'induit aucune orientation préférentielle cristallographique de croissance des couches ultérieures. Il est donc choisi uniquement en raison de ses propriétés connues de très faible rugosité en vue notamment de pouvoir disposer d'une bonne planéité des couches supérieures.

Outre le silicium et le silicium oxydé, ce substrat peut être constitué d'autres matériaux présentant une très faible rugosité de surface, tels que par exemple le nitrure de silicium, le verre fondu. Il peut également être réalisé en alumine ou en oxyde de magnésium.

Par pulvérisation cathodique, on dépose sur ce substrat une couche tampon **1.** Comme déjà indiqué, cette couche tampon assure à la fois la promotion de la croissance des couches supérieures, l'adaptation des paramètres de maille, la mouillabilité desdites couches supérieures, outre leur adhérence et la promotion de la planéité. Cette couche a également pour but de permettre l'amenée du courant électrique traversant le dispositif.

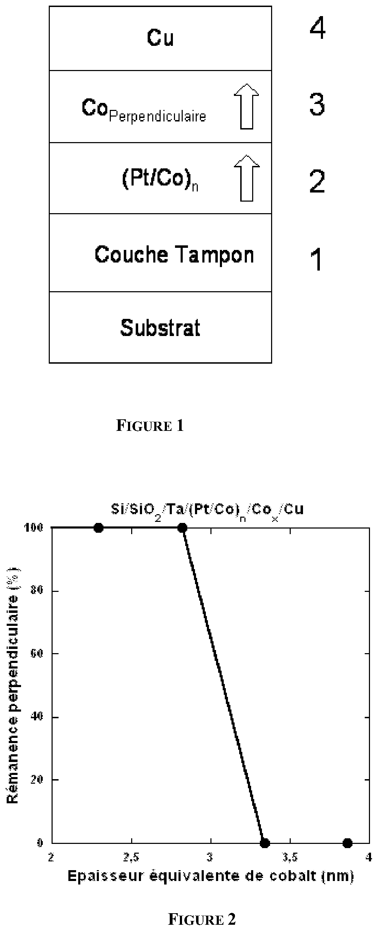

Dans la première forme de réalisation de l'invention plus particulièrement illustrée en relation avec la figure 1, cette couche tampon **1** est constituée d'une épaisse couche de cuivre, surmontée d'une couche de tantale et/ou de platine. L'épaisseur de la couche de tantale est comprise entre 2 et 20 nm, et avantageusement 3 nm. L'épaisseur de la couche de platine est comprise entre 2 et 30 nm, et avantageusement 20 nm.

On dépose ensuite une couche **2**, constituée d'un empilement de couches de platine et de cobalt selon le motif $(Pt/Co)_n$, où n est le nombre de répétitions de l'empilement platine/cobalt.

L'épaisseur des couches de cobalt de la multicouche **2** $(Co/Pt)_n$ est comprise entre 0,2 et 1 nm, avantageusement 0,6 nm. L'épaisseur des couches de platine est comprise entre 0,1 et 2 nm, et avantageusement voisine de 0,3 nm. En outre, le nombre n de répétitions de l'empilement (Co/Pt) est compris entre 1 et 10.

On dépose ensuite sur cette couche **2**, une couche **3**, réalisée en un matériau ferromagnétique à fort taux de polarisation en spin. Dans l'exemple décrit, cette couche **3** est réalisée en cobalt. On pourrait cependant avantageusement substituer le cobalt par un autre matériau magnétique connu pour sa propension à polariser de manière importante le spin des électrons d'un courant la traversant, tel que par exemple le Permalloy $Ni_{80}Fe_{20}$. Un autre avantage du Permalloy déjà mentionné est sa courte longueur de diffusion de spin (~4.5 nm), de sorte qu'en régime diffusif, une épaisseur de Permalloy de l'ordre de 4.5 nm suffit à générer la polarisation maximale que l'on peut attendre de ce matériau (de 50 à 60%).

Cette couche **3** pourra être constituée d'un alliage magnétique binaire ou ternaire d'éléments choisis dans le groupe comprenant le cobalt, le fer, et le nickel. Cet alliage pourra également être cristallisé ou amorphe, et contenir des ajouts de matériaux non magnétiques choisis dans le groupe comprenant le bore, le silicium, le phosphore, le carbone, le zirconium, le hafnium ou leurs alliages. Cette couche **3** pourra être également constituée d'une multicouche de type métal magnétique/métal magnétique ou métal magnétique/métal non magnétique.

Cette couche **3** présente une aimantation orientée naturellement dans son plan lorsqu'elle n'est pas couplée avec la couche précédente **2.**

Enfin, sur la couche **3**, est déposée une couche de cuivre **4**, également par pulvérisation cathodique, d'une épaisseur comprise entre 2 et 10 nm. Cette couche **4** a pour finalité de protéger la couche **3** contre la corrosion, sans néanmoins induire d'effet particulier, tant en ce qui concerne l'éventuelle anisotropie hors du plan de la couche **3** qu'en ce qui concerne une éventuelle dépolarisation des électrons traversant la structure.

Cette couche **4** est également destinée à découpler magnétiquement la couche **3** par rapport à d'autres couches magnétiques susceptibles d'être déposées au dessus, tel que par exemple l'adjonction d'une jonction tunnel en vue de la réalisation d'une cellule MRAM ou d'un oscillateur radiofréquence. Cette couche de cuivre peut également être remplacée par une couche d'oxyde de silicium, d'aluminium ou de magnésium, ou de tout autre matériau ou alliage ne provoquant pas une trop forte dépolarisation des électrons.

La multicouche **2**, de par sa forte anisotropie magnétique perpendiculaire, a pour but de tirer l'aimantation de la couche de cobalt **3** hors du plan. A cet effet, on a démontré qu'il convenait de choisir les épaisseurs respectives de ces deux couches, de telle sorte que la valeur absolue de l'anisotropie effective de la multicouche $(Co/Pt)_n$ soit supérieure à la valeur absolue de l'anisotropie effective de la couche de cobalt.

A l'effet d'illustrer ce propos, on décrit les phénomènes suivants.

Si l'on définit par $m_2$ l'aimantation de la multicouche **2** et $e_2$ son épaisseur, et par $m_3$ et $e_3$, respectivement l'aimantation de la couche de cobalt **3** et son épaisseur, on établit les relations suivantes :

Tout d'abord, l'anisotropie par unité de surface de chacune de ces deux couches est définie par la somme de l'anisotropie magnétocristalline et de l'anisotropie interfaciale. Ainsi, pour la couche **2**, l'anisotropie effective par unité de surface $k_{eff2}$ est définie par la relation suivante :

$$k_{eff2} = k_{v2} \cdot e_2 + k_{s2}$$

où $k_{v2}$ et $k_{s2}$ désignent respectivement l'anisotropie magnétocristalline et l'anisotropie interfaciale de la multicouche **2**.

De la même manière, on peut écrire pour la couche de cobalt **3** :

$$k_{eff3} = k_{v3} \cdot e_3 + k_{s3}.$$

où $k_{v3}$ et $k_{s3}$ désignent respectivement l'anisotropie magnétocristalline et l'anisotropie interfaciale de la couche de cobalt.

Un autre facteur à prendre en considération est l'anisotropie de forme qui tend à maintenir l'aimantation dans le plan de la couche considérée pour minimiser l'énergie magnétostatique, et correspondant au champ démagnétisant. Ainsi, l'anisotropie de forme par unité de surface s'exprime respectivement :

- pour la couche **2** par : $-2\pi.M_2^2.e_2$ ;
- et pour la couche **3** par : $-2\pi.M_3^2.e_3$

où $M_{2(3)}$ désigne l'aimantation spontanée de la couche correspondante.

Enfin, on désigne par A la constante de couplage d'échange au niveau de l'interface entre la multicouche **2** et la couche **3** en cobalt.

L'énergie d'anisotropie par unité de surface de la multicouche **2** s'écrit alors:

$$E = - [(k_{v2}-2\pi M_2^2) e_2 + k_{s2}] \cos^2 \theta_2$$

où $\theta_2$ désigne l'angle de l'aimantation de la couche **2** par rapport à la direction perpendiculaire au plan des couches.

Il résulte de cette expression qu'afin de s'assurer que la couche **2** présente une aimantation résultante hors du plan en l'absence d'interaction avec toute autre couche, on doit vérifier la relation $[(k_{v2}-2\pi.M_2^2)e_2 + k_{s2}] >> 0$, de sorte que l'énergie $[(k_{v2}-2\pi. M_2^2)e_2 + k_{s2}] \cos^2 \theta_2$ est minimisée pour $\theta_2 = 0$, c'est-à-dire pour une aimantation hors du plan.

A cet effet, l'épaisseur de la multicouche **2** doit être suffisamment faible (c'est-à-dire en particulier le nombre de répétitions n) pour que les effets d'anisotropie de forme ne réduisent pas de manière trop importante l'anisotropie perpendiculaire interfaciale.

L'expérience démontre cependant que ce matériau, la multicouche cobalt/platine dans l'exemple décrit, donne une polarisation en spin trop faible ; toute polarisation construite à la traversée d'une couche de cobalt est pratiquement perdue à la traversée de la couche de platine suivante. Aussi, pour augmenter cette polarisation, on couple cette multicouche à une couche plus épaisse de métal magnétique qui, de manière connue, présente une forte polarisation en spin.

En l'espèce, le cobalt cité en exemple pourrait être avantageusement remplacé, comme cela a été dit plus haut, par un alliage de Permalloy $Ni_{80}Fe_{20}$ ou de cobalt-fer CoFe. Cependant, la direction de l'aimantation de ces matériaux, en l'absence de couplage avec la couche **2**, et parallèle au plan, selon l'expression:

$$[(k_{v3}-2\pi M_3^2) e_3 + k_{s3}] < 0.$$

Or, le couplage d'échange entre les aimantations des couches **2** et **3**, selon l'expression - A cos $(\theta_2-\theta_3)$, dans laquelle $\theta_2$ et $\theta_3$ désignent les angles respectifs des aimantations de chacune des deux couches par rapport à la direction perpendiculaire au plan des couches, tend à maintenir les aimantations desdites couches parallèles entre elles.

Ainsi, l'énergie magnétique constituée par l'empilement de ces deux couches **2** et **3** couplées se définit par la relation suivante :

$$E = - [(k_{v2}-2\pi M_2^2) e_2 + k_{s2}] \cos^2 \theta_2 - [(k_{v3}-2\pi M_3^2) e_3 + k_{s3}] \cos^2 \theta_3 - A \cos (\theta_2-\theta_3)$$

Ce faisant, pour que la multicouche cobalt/platine **2** tire l'aimantation de la couche de cobalt ou de permalloy **3** hors du plan, deux conditions sont à remplir :

D'une part, l'anisotropie effective hors du plan de la couche **2** doit être plus forte que l'anisotropie effective planaire de la couche **3** ce qui s'exprime par :

$$[(k_{v2}-2\pi M_2^2) e_2 + k_{s2}] + [(k_{v3}-2\pi M_3^2) e_3 + k_{s3}] > 0$$

D'autre part, dans le cadre du modèle simple présenté ici de deux couches couplées par une constante de couplage A, et à anisotropie respectivement hors du plan pour la couche **2** et planaire pour la couche **3**, l'aimantation de la couche **3** pourra être tirée hors du plan sous l'effet du couplage avec la couche **2** à condition que l'énergie de couplage par unité de surface soit deux fois plus importante que la valeur absolue de l'anisotropie effective de la couche **3** par unité de surface.

S'agissant de la couche **3** (cobalt ou permalloy), plus son épaisseur $e_3$ est grande, plus son pouvoir de polarisation est asymptotiquement important, notamment en relation avec la longueur de diffusion du spin en régime diffusif. Cependant, cette valeur de l'épaisseur ne doit pas atteindre une valeur trop importante, susceptible de faire retomber son aimantation dans le plan, une fois les couches assemblées.

On a représenté avec la figure 2, pour une telle structure, typiquement constituée par un empilement $Si/SiO_2/Ta/(Pt/Co)_n/Co_x/Cu$, la variation de l'aimantation rémanente mesurée avec un champ magnétique appliqué perpendiculairement au plan des couches en fonction de l'épaisseur de cobalt comptée à partir de la dernière couche de platine.

On observe ainsi que l'aimantation rémanente en champ nul de 100%, correspondant à la caractéristique selon laquelle l'aimantation de la couche de cobalt est perpendiculaire au plan des couches, subsiste pour des épaisseurs de cobalt voisines de 2,8 nm. Corollairement, l'aimantation rémanente de 0%, signifiant que l'aimantation de la couche de cobalt est parallèle au plan des couches, intervient pour une épaisseur de cobalt supérieure à 3 nm.

Selon la configuration de cette première forme de réalisation, et pour des épaisseurs de cobalt inférieures à 3 nm, on peut ainsi réaliser un polariseur perpendiculaire tel que visé en introduction.

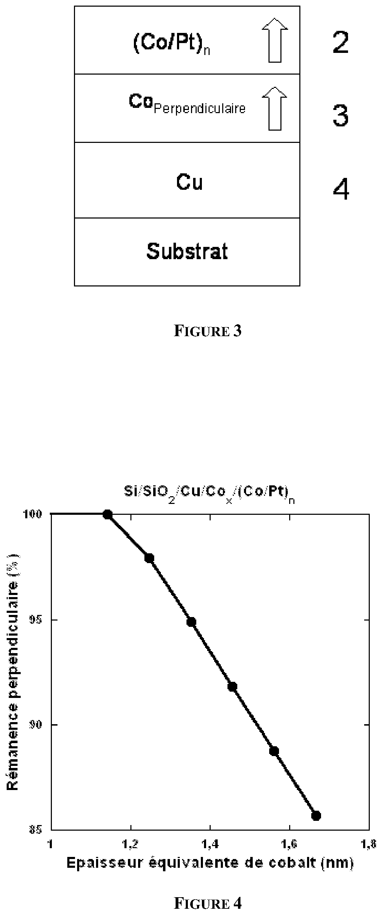

Dans une deuxième forme de réalisation, représentée en relation avec la figure 3, on inverse la structure décrite dans l'exemple précédent, puisqu'on aboutit à la succession substrat/cuivre/cobalt (matériau ferromagnétique)/multicouche $(Co/Pt)_n$. Ce mode de réalisation est le symétrique du mode de réalisation précédent, la couche « utile » **3** de cobalt étant maintenant, par référence à l'ordre de dépôt des différentes couches, en dessous de la multicouche **2** cobalt/platine.

L'épaisseur des couches de cobalt de la multicouche **2** cobalt/platine est comprise entre 0,2 et 1 nm, et avantageusement fixée à 0,6 nm. L'épaisseur des couches de platine de la multicouche **2** cobalt/platine est comprise entre 0,2 et 2 nm, et avantageusement fixée à 1,6 nm.

Le nombre de répétitions de l'empilement cobalt/platine est compris entre 1 et 10, et avantageusement fixé à 5.

On a représenté en relation avec la figure 4 pour une telle structure, et plus particulièrement la structure $Cu/Co/(Co_{0,6}/Pt_{1,6})_5/Pt$, la variation de l'aimantation rémanente mesurée avec un champ magnétique appliqué perpendiculairement au plan des couche en fonction de l'épaisseur de cobalt.

On peut observer qu'une aimantation rémanente en champ nul de 100% correspondant à l'aimantation de la couche « utile » **3** de cobalt perpendiculaire au plan des couches apparaît pour des épaisseurs de cobalt inférieures à 1,2 nm.

Corollairement, une aimantation rémanente inférieure à 100%, correspondant au fait qu'une partie de l'aimantation des couches magnétiques est parallèle au plan des couches, intervient pour des épaisseurs supérieures à 1,2 nm.

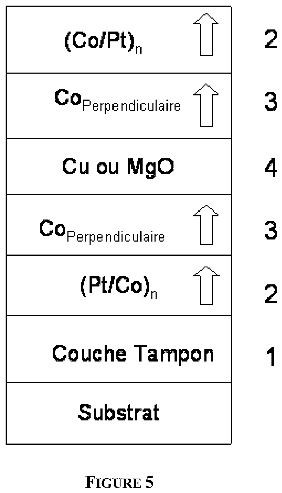

Dans un troisième mode de réalisation, on peut, en combinant les deux modes de réalisation précédents, réaliser une structure complète du type notamment « vanne de spin » ou «jonction tunnel magnétique » à aimantation perpendiculaire, ainsi que décrit schématiquement sur la figure 5, dans laquelle chacune des couches magnétiques « active » de la jonction ou de la vanne de spin a été réalisée selon l'un des deux premiers modes de réalisation. Lorsque l'on souhaitera réaliser une mémoire magnétique MRAM, les structures de la première et de la deuxième forme de réalisation seront séparées par exemple par une couche conductrice non magnétique, ou une barrière tunnel de type $Al_2O_3$ ou MgO.

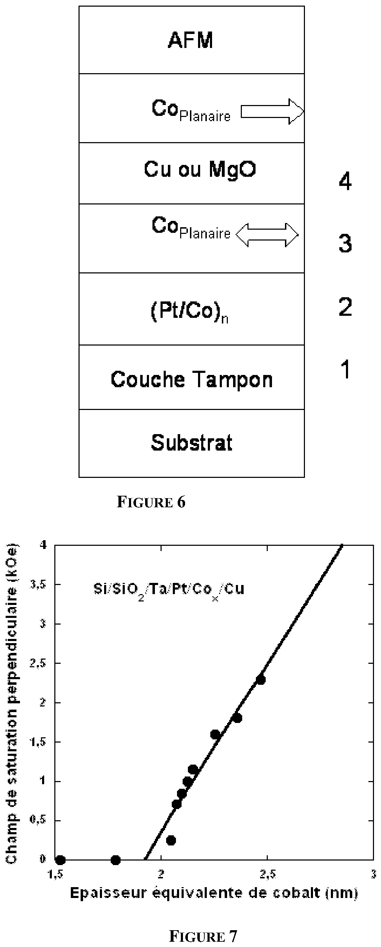

Dans un quatrième mode de réalisation, en relation avec la figure 6, on utilise l'empilement présenté dans le premier mode de réalisation, cette fois-ci en tant que « couche libre » dans une structure de type vanne de spin ou jonction tunnel à aimantation planaire. La couche dite « piégée » peut avoir la structure habituelle, à savoir par exemple un matériau magnétique classique à aimantation planaire couplé par échange à un matériau antiferromagnétique (AFM).

Pour un empilement du type de celui représenté à la figure 6, la figure 7 représente la variation du champ de saturation (le champ magnétique est toujours appliqué dans une direction perpendiculaire au plan des couches) en fonction de l'épaisseur de cobalt (couche **3**). Ce champ de saturation représente l'intensité du champ magnétique nécessaire pour forcer l'aimantation du cobalt, naturellement parallèle au plan de la couche pour des épaisseurs supérieures à 2 nm environ d'après la figure 6, à s'orienter dans une direction perpendiculaire au plan.

On observe ainsi que les valeurs de ce champ de saturation sont bien inférieures à celles qui seraient nécessaires (à savoir de l'ordre de 18 kOe) dans le cas d'une couche de cobalt de même épaisseur en l'absence du terme d'anisotropie perpendiculaire apporté par l'interaction entre la couche **2** et la couche magnétique **3**.

En d'autres termes, ce graphe illustre la réduction du champ de saturation perpendiculaire lorsque l'on réduit l'épaisseur de cobalt, notamment jusqu'à des épaisseurs de l'ordre de 2 nm. Lorsque l'on souhaitera disposer d'une couche à aimantation planaire mais à faible champ démagnétisant, c'est-à-dire dans le cadre de la mise en oeuvre du dispositif magnétique de l'invention en relation avec des mémoires magnétiques dans lesquelles on réalise le renversement de l'aimantation en utilisant un courant polarisé en spin, on va donc choisir une épaisseur de cobalt légèrement supérieure à 2 nm pour l'exemple décrit ici.

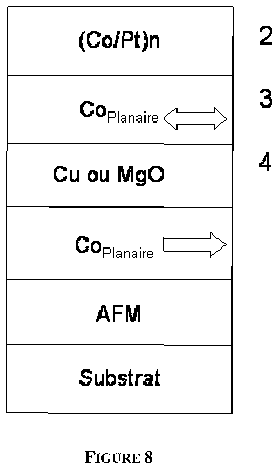

Dans un cinquième mode de réalisation, en relation avec la figure 8, on utilise l'empilement présenté dans le deuxième mode de réalisation, cette fois-ci en tant que "couche libre" dans une structure de type vanne de spin ou jonction tunnel magnétique à aimantation planaire. La couche dite "piégée" peut avoir la structure habituelle, à savoir par exemple un matériau magnétique classique à aimantation planaire couplé par échange à un matériau antiferromagnétique (AFM).

Comme dans le cas du quatrième mode de réalisation, on disposera donc également d'une couche libre à aimantation planaire mais à faible champ démagnétisant, cette couche libre étant, dans ce mode de réalisation, située au dessus de la couche piégée en référence à l'ordre de dépôts des différentes couches du dispositif.

## Revendications

**1.** Dispositif magnétique en couches minces comprenant sur un substrat un ensemble composite déposé par pulvérisation cathodique et constitué :

- d'une première couche (2), réalisée en un matériau magnétique à anisotropie magnétique effective positive, dont l'aimantation en l'absence de toute interaction électrique ou magnétique est située hors du plan de ladite couche, et dont l'anisotropie positive effective par unité de surface $k_{eff2}$ incluant des contributions volumique et interfaciale est donnée en unités CGS par : $[(k_{v2}-2\pi M^2_2)e_2 + k_{s2}]$ où

- $k_{v2}$ est l'anisotropie volumique de la première couche ;
- $M_2$ est l'aimantation de la première couche ;
- $e_2$ est l'épaisseur de la première couche ;
- $k_{s2}$ est l'anisotropie interfaciale de la première couche ;

- d'une deuxième couche (3) réalisée en un matériau ayant une anisotropie effective négative, ladite anisotropie effective négative $k_{eff3}$ par unité de surface incluant des contributions volumique et interfaciale est donnée en unités CGS par : $[(k_{v3}-2\pi M^2_3) e_3 + k_{s3}]$ où

- $k_{v3}$ est l'anisotropie volumique de la deuxième couche ;
- $M_3$ est l'aimantation de la deuxième couche ;
- $e_3$ est l'épaisseur de la deuxième couche ;
- $k_{s3}$ est l'anisotropie interfaciale de la deuxième couche ;

ladite deuxième couche magnétique (3) en permalloy, ayant un taux de polarisation en spin des électrons de 50% à 60 % lorsqu'elle est traversée par un courant électrique circulant perpendiculairement au plan de cette deuxième couche magnétique ;
- d'une troisième couche non magnétique (4), en contact direct avec la deuxième couche magnétique (3) par son interface opposée à la première couche magnétique, réalisée en un matériau non dépolarisant pour les électrons traversant cette troisième couche non-magnétique,

dispositif magnétique *caractérisé :*

- **en ce que** la première couche (2) à anisotropie effective perpendiculaire au plan des couches est constituée d'un matériau, d'un alliage ou d'une multicouche de matériaux choisis dans le groupe comprenant le cobalt, le platine, le fer, le nickel, le palladium, l'or et le cuivre ;
- **en ce que** l'énergie de couplage par unité de surface entre la première couche magnétique (2) et la deuxième couche magnétique (3) a une amplitude d'au moins deux fois la valeur absolue de l'énergie d'anisotropie effective négative de la seconde couche magnétique ;
- et **en ce que** ledit dispositif comprend des moyens pour faire circuler un courant électrique à travers ses couches dans une direction sensiblement perpendiculaire au plan desdites couches.

**2.** Dispositif magnétique en couches minces selon la revendication 1, *caractérisé* **en ce que** son aimantation résultante est orientée perpendiculairement au plan des couches qui le constituent.

**3.** Dispositif magnétique en couches minces selon l'une des revendications 1 et 2, *caractérisé* **en ce que** la deuxième couche magnétique (3) est constituée d'un matériau magnétique choisi dans le groupe comprenant le cobalt, le fer, le nickel, ou leurs alliages binaires, ou ternaires.

4. Dispositif magnétique en couches minces selon l'une des revendications 1 et 2, *caractérisé* **en ce que** le matériau magnétique constitutif de la deuxième magnétique couche (3) est cristallisé ou amorphe, et contient des ajouts de matériaux non magnétiques choisis dans le groupe comprenant le bore, le silicium, le phosphore, le carbone, le zirconium, le hafnium ou leurs alliages.

5. Dispositif magnétique en couches minces selon l'une des revendications 1 et 2, *caractérisé* **en ce que** la deuxième couche magnétique (3) est constituée d'une multicouche de type métal magnétique/métal magnétique ou métal magnétique/métal non magnétique.

6. Dispositif magnétique en couches minces selon l'une des revendications 1 et 2, *caractérisé* **en ce que** la troisième couche non magnétique (4) est réalisée soit en un métal non magnétique, soit en un oxyde non magnétique.

7. Dispositif magnétique en couches minces selon l'une des revendications 1 à 6, *caractérisé* **en ce que** l'on intercale entre le substrat et l'ensemble composite une couche tampon (1).

8. Dispositif magnétique en couches minces selon la revendication 7, *caractérisé* **en ce que** la couche tampon est réalisée en un ou plusieurs matériaux choisis dans le groupe comprenant le platine, le tantale, le chrome, le titane, le nitrure de titane, le cuivre, l'or, le palladium, l'argent et leurs alliages.

9. Dispositif magnétique en couches minces selon la revendication 7, *caractérisé* **en ce que** la couche tampon est constituée d'une pluralité de couches.

10. Dispositif magnétique en couches minces selon l'une des revendications 1 à 9, *caractérisé* **en ce que** le substrat est réalisé en un matériau choisi dans le groupe comprenant le silicium, la silice, le nitrure de silicium, l'oxyde de magnésium, l'alumine et le verre.

11. Jonction tunnel magnétique à aimantation planaire, *caractérisée* **en ce qu'**elle comprend, en plus de ses deux couches magnétiques actives, une multicouche supplémentaire à aimantation hors du plan c'est-à-dire satisfaisant la condition $k_{eff2} + k_{eff3} > 0$, réalisée selon l'une des revendications 1 à 10.

12. Jonction tunnel magnétique à aimantation planaire, *caractérisée* **en ce qu'**au moins l'une de ses deux couches magnétiques actives est constituée d'un dispositif magnétique à aimantation planaire selon l'une des revendications 1 à 10, satisfaisant à la condition $k_{eff2} + k_{eff3} < 0$.

13. Jonction tunnel magnétique à aimantation perpendiculaire, *caractérisée* **en ce qu'**au moins l'une des deux couches magnétiques actives est constituée d'un dispositif magnétique à aimantation perpendiculaire selon l'une des revendications 1 à 10, satisfaisant à la condition $k_{eff2} + k_{eff3} > 0$.

14. Vanne de spin à aimantation planaire *caractérisée* **en ce qu'**elle comprend, en plus de ses deux couches actives, une couche polarisante à aimantation perpendiculaire c'est-à-dire satisfaisant la condition $k_{eff2} + k_{eff3} > 0$, constituée d'un dispositif magnétique selon l'une des revendications 1 à 10.

15. Vanne de spin à aimantation planaire, *caractérisée* **en ce qu'**au moins l'une de ses deux couches magnétiques actives est constituée d'un dispositif magnétique à aimantation planaire selon l'une des revendications 1 à 10, satisfaisant à la condition $k_{eff2} + k_{eff3} < 0$.

16. Vanne de spin à aimantation perpendiculaire, *caractérisée* **en ce qu'**au moins l'une de ses deux couches magnétiques actives est constituée d'un dispositif magnétique à aimantation perpendiculaire selon l'une des revendications 1 à 10, satisfaisant à la condition $k_{eff2} + k_{eff3} > 0$.

**Patentansprüche**

1. Dünnschichtige Magnetvorrichtung, die auf einem Substrat eine durch Kathodenspritzen aufgebrachte Verbundanordnung enthält und die besteht aus:

- einer ersten Schicht (2) aus einem Material mit effektiver positiver magnetischer Anisotropie, deren Magnetisierung in Abwesenheit von jeglicher elektrischer oder magnetischer Wechselwirkung sich außerhalb der Ebene dieser Schicht befindet und deren positive effektive Anisotropie pro Flächeneinheit $k_{eff2}$ einschließlich des Volumen- und Grenzflächenbeitrags in CGS- Einheiten angegeben ist durch:

$$[(k_{V2}-2\pi M^2_2)\, e_2 + k_{s2}],$$

worin

- $k_{V2}$ die Volumenanisotropie der ersten Schicht ist;
- $M_2$ die Magnetisierung der ersten Schicht ist;
- $e_2$ die Dicke der ersten Schicht ist;
- $k_{s2}$ die Grenzflächenanisotropie der ersten Schicht ist;

- einer zweiten Schicht (3) aus einem Material mit negativer effektiver Anisotropie, wobei diese negative effektive Anisotropie $k_{eff3}$ pro Flächeneinheit einschließlich des Volumen- und Grenzflächenbeitrags in CGS-Einheiten durch: $[(k_{V3}-2\pi M^2_3)\, e_3 + k_{s3}]$ angegeben ist, worin

- $k_{V3}$ die Volumenanisotropie der zweiten Schicht ist;
- $M_3$ die Magnetisierung der zweiten Schicht ist;
- $e_3$ die Dicke der zweiten Schicht ist;
- $k_{s3}$ die Grenzflächenanisotropie der zweiten Schicht ist;

wobei diese zweite Magnetschicht (3) aus Mu-Metall mit einem Elektronen-Spinpolarisationsgrad von 50% bis 60 % besteht, wenn durch sie ein elektrischer Strom senkrecht zur Ebene dieser zweiten Magnetschicht fließt;
- einer dritten, nicht-magnetischen Schicht (4), in direktem Kontakt mit der zweiten Magnetschicht (3) durch die Grenzfläche, die der ersten Magnetschicht entgegengesetzt ist, ausgeführt aus einem nicht depolarisierenden Material für die Elektronen, die durch diese dritte, nicht-magnetischen Schicht (4) hindurchgehen, Magnetvorrichtung, **dadurch gekennzeichnet:**

- **dass** die erste Schicht (2) mit effektiver Anisotropie senkrecht zur Ebene der Schichten, aus einem Material, einer Legierung oder einem Schichtstoff, aus Materialien, die aus der Gruppe ausgewählt werden, zu der Kobalt, Platin, Eisen, Nickel, Palladium, Gold und Kupfer gehören, besteht;
- dadurch, dass die Kopplungsenergie pro Flächeneinheit zwischen der ersten Magnetschicht (2), und der zweiten Magnetschicht (3) eine Amplitude aufweist, die mindestens zwei Mal den absoluten Wert der effektiven negativen Anisotropieenergie der zweiten Magnetschicht (3) aufweist;
- und dadurch, dass diese Vorrichtung Elemente umfasst, um einen elektrischen Strom durch ihre Schichten fließen zu lassen, in einer Richtung, die im Wesentlichen senkrecht zur Ebene dieser Schichten liegt.

2. Dünnschichtige Magnetvorrichtung nach Anspruch 1, *dadurch gekennzeichnet,* **dass** die resultierende Magnetisierung senkrecht zur Ebene der Schichten, aus denen sie besteht, orientiert ist.

3. Dünnschichtige Magnetvorrichtung nach einem der Ansprüche 1 und 2, *dadurch gekennzeichnet,* **dass** die zweite Magnetschicht (3) aus einem magnetischen Material, das aus der Gruppe ausgewählt wird, zu der Kobalt, Eisen, Nickel oder ihre binären oder ternären Legierungen gehören, besteht.

4. Dünnschichtige Magnetvorrichtung nach einem der Ansprüche 1 und 2, *dadurch gekennzeichnet,* **dass** das magnetische Material, das die zweite Magnetschicht (3) bildet, kristallisiert oder amorph ist und Zuschläge nicht magnetischer Materialien enthält, die aus der Gruppe ausgewählt werden, zu der Bor, Silizium, Phosphor, Kohlenstoff, Zirkonium, Hafnium oder ihre Legierungen gehören.

5. Dünnschichtige Magnetvorrichtung nach einem der Ansprüche 1 und 2, *dadurch gekennzeichnet,* **dass** die zweite Magnetschicht (3) aus einem mehrschichtigen Material vom Typ magnetisches Metall/ magnetisches Metall oder magnetisches Metall/nicht-magnetisches Metall besteht.

6. Dünnschichtige magnetische Vorrichtung, nach einem der Ansprüche 1 bis 2, *dadurch gekennzeichnet,* **dass** die dritte, nicht-magnetische Schicht (4) entweder aus einem nicht-magnetischen Metall oder einem nicht-magnetischen Oxid besteht.

7. Dünnschichtige Magnetvorrichtung nach einem der Ansprüche 1 bis 2, *dadurch gekennzeichnet,* **dass** zwischen dem Substrat und der Verbundeinheit eine Pufferschicht (1) eingefügt wird.

8. Dünnschichtige Magnetvorrichtung nach Anspruch 7, *dadurch gekennzeichnet,* **dass** die Pufferschicht aus einem oder mehreren Materialien, die aus der Gruppe ausgewählt werden, zu der Platin, Tantal, Chrom, Titan, Titannitrid, Kupfer, Gold, Palladium, Silber oder ihre Legierungen gehören, besteht.

9. Dünnschichtige Magnetvorrichtung nach Anspruch 7, *dadurch gekennzeichnet,* **dass** die Pufferschicht aus einer Vielzahl von Schichten besteht.

10. Dünnschichtige magnetische Vorrichtung, nach einem der Ansprüche 1 bis 9, *dadurch gekennzeichnet,* **dass** das Substrat aus einem Material, das aus der Gruppe ausgewählt wird, zu der Silizium, Kieselerde, Siliziumnitrid, Magnesiumoxid, Tonerde und Glas gehören, besteht.

11. Magnetischer Tunnelübergang mit planarer Magnetisierung, *dadurch gekennzeichnet,* **dass** er außer seinen beiden aktiven Magnetschichten eine zusätzliche mehrlagige Schicht mit Magnetisierung außerhalb der Ebene enthält, das heißt, die die Bedingung $k_{eff2} + k_{eff3} > 0$, erfüllt, enthält, ausgeführt nach einem der Ansprüche 1 bis 10.

12. Magnetischer Tunnelübergang mit planarer Magnetisierung, *dadurch gekennzeichnet,* **dass** mindestens eine seiner beiden aktiven Magnetschichten aus einer Magnetvorrichtung mit planarer Magnetisierung nach einem der Ansprüche 1 bis 10 besteht, die die Bedingung $k_{eff2} + k_{eff3} < 0$ erfüllt.

13. Magnetischer Tunnelübergang mit senkrechter Magnetisierung, *dadurch gekennzeichnet,* **dass** mindestens eine seiner beiden aktiven Magnetschichten aus einer Magnetvorrichtung mit senkrechter Magnetisierung nach einem der Ansprüche 1 bis 10 besteht, die die Bedingung $k_{eff2} + k_{eff3} > 0$ erfüllt.

14. Spinventil mit planarer Magnetisierung, **dadurch gekennzeichnet, dass** es außer seinen beiden aktiven Magnetschichten eine polarisierende Schicht mit senkrechter Magnetisierung enthält, das heißt, die die Bedingung $k_{eff2} + k_{eff3} > 0$, erfüllt, enthält, bestehend aus einer Magnetvorrichtung nach einem der Ansprüche 1 bis 10.

15. Spinventil mit planarer Magnetisierung, **dadurch gekennzeichnet, dass** mindestens eine seiner beiden aktiven Magnetschichten aus einer Magnetvorrichtung mit planarer Magnetisierung nach einem der Ansprüche 1 bis 10 besteht, die die Bedingung $k_{eff2} + k_{eff3} < 0$ erfüllt.

16. Spinventil mit planarer Magnetisierung, **dadurch gekennzeichnet, dass** mindestens eine seiner beiden aktiven Magnetschichten aus einer Magnetvorrichtung mit senkrechter Magnetisierung, nach einem der Ansprüche 1 bis 10 besteht, die die Bedingung $k_{eff2} + k_{eff3} > 0$ erfüllt.


**Claims**

1. A thin-film magnetic device comprising, on a substrate, a composite assembly deposited by cathode sputtering and consisting of:

   - a first layer (2), made of a magnetic material with positive effective magnetic anisotropy, whose magnetisation in the absence of any electric or magnetic interaction is located outside the plane of said layer, and whose positive effective anisotropy per surface unit $k_{eff2}$ including volume and interfacial contributions is given in CGS units by $[(k_{v2}-2\pi M_2^2)e_2 + k_{s2}]$, where :

       - $k_{v2}$ is the volume anisotropy of the first layer ;
       - $M_2$ is the magnetization of the first layer ,
       - $e_2$ is the thickness of the first layer ;
       - $k_{s2}$ is the interfacial anisotropy oft he first layer ;

   - a second layer (3), made of a material with negative effective anisotropy, , and whose negative effective

**14**

anisotropy per surface unit $k_{eff3}$ including volume and interfacial contributions is given in CGS units by $[(k_{v3}-2\pi M^2_3) e_3 + k_{s3}]$, where :

- $k_{v3}$ is the volume anisotropy of the second layer ;
- $M_3$ is the magnetization of the second layer ,
- $e_3$ is the thickness of the second layer ;
- $k_{s3}$ is the interfacial anisotropy oft he first layer ;

said second magnetic layer (3) made of permalloy, having a rate of spin polarization of the electrons of 50 to 60 % when an electric current flows through said layer in a direction perpendicular to its plane ;
- a third non-magnetic layer (4), in direct contact with the second magnetic layer (3) with its interface opposed to the first magnetic layer, made of a material that is not polarising for electrons passing through this third non-magnetic layer,

magnetic device ***characterized***:

- **in that** the first layer (2) with effective anisotropy perpendicular to the plane of the layers is made of a material, alloy or multilayer of materials selected from the group comprising cobalt, platinum, iron, nickel, palladium, gold and copper ;
- **in that** the coupling energy per unit of surface area between the first magnetic layer (2) and the second magnetic layer (3) is at least twice the absolute value of the negative effective anisotropy of the second magnetic layer (3) ;
- and **in that** said device also comprises means of causing an electric current to flow through its layers in a direction substantially perpendicular to their plane.

2. A thin-film magnetic device as claimed in claim 1, ***characterised* in that** its resultant magnetisation is oriented perpendicular to the plane of the layers that constitute it.

3. A thin-film magnetic device as claimed in any of claims 1 to 2, ***characterised* in that** the second magnetic layer (3) consists of a magnetic material selected from the group comprising cobalt, iron, nickel or binary or ternary alloys thereof.

4. A thin-film magnetic device as claimed in any of claims 1 to 2, ***characterised* in that** the magnetic material that constitutes the second magnetic layer (3) is crystallised or amorphous and contains added non-magnetic materials selected from the group comprising boron, silicon, phosphorus, carbon, zirconium, hafnium or alloys thereof.

5. A thin-film magnetic device as claimed in any of claims 1 to 2, ***characterised* in that** the second magnetic layer (3) consists of a multilayer of the magnetic metal/magnetic metal or magnetic metal/non-magnetic metal type.

6. A thin-film magnetic device as claimed in any of claims 1 to 2, ***characterised* in that** the third non-magnetic layer (4) is made of a non-magnetic metal or a non-magnetic oxide.

7. A thin-film magnetic device as claimed in any of claims 1 to 6, ***characterised* in that** a buffer layer (1) is interposed between the substrate and the composite assembly.

8. A thin-film magnetic device as claimed in claim 7, ***characterised* in that** said buffer layer (1) is made of one or more materials selected from the group comprising platinum, tantalum, chromium, titanium, titanium nitride, copper, gold, palladium, silver or alloys thereof.

9. A thin-film magnetic device as claimed in claim 7, ***characterised* in that** said buffer layer (1) consists of a plurality of layers.

10. A thin-film magnetic device as claimed in any of claims 1 to 9, ***characterised* in that** the substrate is made of a material selected from the group comprising silicon, silica, silicon nitride, magnesium oxide, alumina and glass.

11. A magnetic tunnel junction with planar magnetisation ***characterised* in that** it comprises, besides its two active magnetic layers, an additional multilayer made with magnetization outside the plane, i.e. fulfilling the condition $k_{eff2} + k_{eff3} > 0$, realized according to any of claims 1 to 10.

**12.** A magnetic tunnel junction with planar magnetisation *characterised* in that at least one of its two active magnetic layers is made of a magnetic device with planar magnetization according to any of claims 1 to 10, fulfilling the condition $k_{eff2} + k_{eff3} < 0$.

**13.** A magnetic tunnel junction with perpendicular magnetisation *characterised* in that at least one of its two active magnetic layers is made of a magnetic device with perpendicular magnetization according to any of claims 1 to 10, fulfilling the condition $k_{eff2} + k_{eff3} > 0$.

**14.** A spin valve with planar magnetisation *characterised* in that it comprises, besides its two active magnetic layers, a polarizing layer with perpendicular magnetization, i.e. fulfilling the condition $k_{eff2} + k_{eff3} > 0$, consisting of a magnetic device according to any of claims 1 to 10.

**15.** A spin valve with planar magnetisation *characterised* in that at least one of its two active magnetic layers is made of a magnetic device with planar magnetization according to any of claims 1 to 10, fulfilling the condition $k_{eff2} + k_{eff3} < 0$.

**16.** A spin valve with perpendicular magnetisation *characterised* in that at least one of its two active magnetic layers is made is made of a magnetic device with perpendicular magnetization according to any of claims 1 to 10, fulfilling the condition $k_{eff2} + k_{eff3} > 0$.

| | |
|---|---|
| Cu | 4 |
| Co<sub>Perpendiculaire</sub> ⇧ | 3 |
| (Pt/Co)<sub>n</sub> ⇧ | 2 |
| Couche Tampon | 1 |
| Substrat | |

**FIGURE 1**

Si/SiO$_2$/Ta/(Pt/Co)$_n$/Co$_x$/Cu

**FIGURE 2**

| (Co/Pt)$_n$ | ⇧ | 2 |
| Co$_{Perpendiculaire}$ | ⇧ | 3 |
| Cu | | 4 |
| Substrat | | |

FIGURE 3

Si/SiO$_2$/Cu/Co$_x$/(Co/Pt)$_n$

FIGURE 4

| | |
|---|---|
| (Co/Pt)$_n$ ⇧ | 2 |
| Co$_{Perpendiculaire}$ ⇧ | 3 |
| Cu ou MgO | 4 |
| Co$_{Perpendiculaire}$ ⇧ | 3 |
| (Pt/Co)$_n$ ⇧ | 2 |
| Couche Tampon | 1 |
| Substrat | |

FIGURE 5

**FIGURE 6**

**FIGURE 7**

| | |
|---|---|
| (Co/Pt)n | 2 |
| Co$_{Planaire}$ ⟺ | 3 |
| Cu ou MgO | 4 |
| Co$_{Planaire}$ ⟹ | |
| AFM | |
| Substrat | |

FIGURE 8

## RÉFÉRENCES CITÉES DANS LA DESCRIPTION

**Documents brevets cités dans la description**

- US 5695864 A
- US 6532164 B
- US 6835646 B
- US 6844605 B
- US 2002101692 A1

**Littérature non-brevet citée dans la description**

- **DAALDEROP ; KELLY ; DEN BROEDER.** *Physical Review Letters,* 1992, vol. 68, 682
- **RAVELOSONA et al.** *Physical Review Letters,* 2005, vol. 95, 117203
- **NISHIMURA et al.** *Journal of Applied Physics,* 2002, vol. 91, 5246